# FASCICULE DE BREVET EUROPEEN

(11) **EP 4 374 489 B1**
(45) Date de publication et mention de la délivrance du brevet: **13.05.2026**
(21) Numéro de dépôt: 22854160.3
(22) Date de dépôt: 27.12.2022
(51) Int. Cl.: H02S 20/10, H02S 30/00

(54) **MODULE PHOTOVOLTAÏQUE TRIDIMENSIONNEL**
DREIDIMENSIONALES FOTOVOLTAISCHES MODUL
THREE-DIMENSIONAL PHOTOVOLTAIC MODULE

(30) Priorité: 30.12.2021 FR 2114686
(43) Date de publication de la demande: 29.05.2024
(73) Titulaire: Gauthier, Sylvain, 06360 Éze (FR)
(72) Inventeur: Gauthier, Sylvain, 06360 Éze (FR)
(74) Mandataire: Germain Maureau
(86) Numéro de dépôt international: PCT/FR2022/052508
(87) Numéro de publication internationale: WO 2023/126611

(56) Documents cités:
- WO-A1-2020/153534
- CN-U- 203 071 100
- US-A1- 2011 083 718

## Description

### Domaine technique

La présente invention concerne de manière générale le domaine de l'énergie solaire photovoltaïque. Elle vise plus précisément un module photovoltaïque tridimensionnel.

### Etat de la technique

Dans le domaine de l'énergie solaire photovoltaïque, il est connu d'utiliser, de manière générale, des panneaux photovoltaïques en deux dimensions constitués par la superposition de plusieurs couches consistant généralement de haut en bas en :
- un revêtement antireflet pour limiter la réflexion des rayons solaires sur les couches semi-conductrices sous-jacentes ;
- une couche de verre protectrice pour protéger les couches semi-conductrices sous-jacentes ;
- une grille conductrice ;
- une couche de semi-conducteur dopé N ou P ;
- une couche de semi-conducteur dopé P ou N ; et
- une couche de base.

L'inconvénient majeur de ce type de panneaux photovoltaïques réside dans la faible quantité d'énergie produite par m². En effet, avec un panneau photovoltaïque bidimensionnel, la quantité d'énergie produite par m² n'est pas optimisée.

De plus, ce type de panneau photovoltaïque n'a pas une production d'énergie homogène au cours de la journée. En effet, cette production suit une loi gaussienne, maximale lorsque le Soleil est à son point de culmination, et plus faible le reste de la journée et en particulier en début et en fin de journée.

Par ailleurs, la solution classique nécessite d'orienter le panneau photovoltaïque de façon optimale par rapport au rayonnement solaire, ce qui n'est pas toujours aisé selon la configuration de l'édifice recevant un tel panneau photovoltaïque.

Pour pallier de tels inconvénients, il est connu de réaliser un module photovoltaïque tridimensionnel comportant:
- une structure de support tridimensionnelle ayant une forme pyramidale à base carrée, et comprenant quatre faces de support ayant chacune une forme triangulaire ; et
- une pluralité de revêtements photovoltaïques fixés à la structure de support tridimensionnelle, chaque revêtement photovoltaïque étant disposé sur une face de support respective et s'étendant sensiblement parallèlement à la face de support respective, chaque revêtement photovoltaïque comprenant au moins une cellule photovoltaïque et recouvrant au moins en partie la face de support respective.

Une telle configuration du module photovoltaïque tridimensionnel permet d'augmenter la surface développée recouverte de matière photovoltaïque active, et donc de produire, lorsque le Soleil est à son point de culmination et que le module photovoltaïque tridimensionnel est disposé sur une surface horizontale, plus d'énergie par unité de surface qu'un panneau photovoltaïque classique.

Cependant, en raison des ombres portées générées par la structure de support tridimensionnelle durant la course de déplacement du Soleil au cours d'une journée, la quantité d'énergie produite annuellement par un tel module photovoltaïque tridimensionnel n'est pas optimale. De plus, à certains instants de la course de déplacement du Soleil, certains des revêtements photovoltaïques ne sont pas insolés et génèrent des charges résistives qui s'opposent à l'énergie fournie par les revêtements photovoltaïques insolés, ce qui limite encore la quantité d'énergie produite annuellement par un tel module photovoltaïque tridimensionnel.

En outre, lorsqu'une pluralité de modules photovoltaïques tridimensionnels du type précité sont assemblés les uns aux autres pour former un dispositif photovoltaïque, chaque structure de support tridimensionnelle génère, lors de la course de déplacement du Soleil, des ombres, voire de l'obscurité, sur les revêtements photovoltaïques des modules photovoltaïques tridimensionnels adjacents, ce qui limite donc considérablement la quantité d'énergie produite annuellement par un tel dispositif photovoltaïque.

Le document US2011/083718A1 décrit un module photovoltaïque tridimensionnel.

### Résumé de l'invention

La présente invention vise à remédier aux inconvénients précédemment cités.

Le problème technique à la base de l'invention consiste donc à fournir un module photovoltaïque tridimensionnel permettant de produire annuellement plus d'énergie par unité de surface qu'un module photovoltaïque tridimensionnel classique.

A cet effet, la présente invention concerne un module photovoltaïque tridimensionnel comportant :
- une structure de support tridimensionnelle comportant un axe central et une pluralité d'éléments de support répartis autour de l'axe central de la structure de support tridimensionnelle, chaque élément de support comportant un sommet et deux faces de support qui sont sensiblement planes et qui sont reliées l'une à l'autre le long d'une ligne de crête, la ligne de crête de chacun des éléments de support étant inclinée par rapport à l'axe central de la structure de support tridimensionnelle et s'étendant jusqu'au sommet de l'élément de support respectif en s'éloignant de l'axe central de la structure de support tridimensionnelle,
- une pluralité de revêtements photovoltaïques fixés à la structure de support tridimensionnelle, chaque revêtement photovoltaïque étant disposé sur une face de support respective et s'étendant sensiblement parallèlement à la face de support respective, chaque revêtement photovoltaïque comprenant au moins une cellule photovoltaïque et recouvrant au moins en partie la face de support respective.

Une telle configuration de la structure de support tridimensionnelle, et donc de l'orientation des différents revêtements photovoltaïques, permet de maximiser la surface insolée du module photovoltaïque tridimensionnel à chaque instant de la course de déplacement du Soleil, et donc de capter une quantité d'énergie importante provenant du Soleil, et ce sans requérir à un quelconque mécanisme de déplacement configuré pour modifier l'orientation du module photovoltaïque tridimensionnel en fonction de la position du Soleil.

En particulier, la disposition des éléments de support limite le phénomène d'ombres portées généré par chaque élément de support sur les autres éléments de support de la structure de support tridimensionnelle, et donc sur les revêtements photovoltaïques disposés sur les faces de support des autres éléments de support de la structure de support tridimensionnelle, tout en permettant une bonne pénétration lumineuse au sein du module photovoltaïque tridimensionnel.

De plus, compte tenu de la disposition des éléments de support, et donc des faces de support, tous les revêtements photovoltaïques sont au moins en partie simultanément insolés durant une partie importante de la course de déplacement du Soleil, ce qui assure une meilleure régularité de la production d'énergie au cours d'une journée (et notamment durant les phases ascendante et descendante du Soleil) et donc également au cours de l'année. La disposition des éléments de support permet également de produire de l'électricité plus tôt dans la journée et jusque plus tard dans la journée comparativement aux modules photovoltaïques tridimensionnels de l'art antérieur.

En outre, lorsqu'un revêtement photovoltaïque n'est pas directement insolé (du fait de l'ombre propre générée par l'élément de support respectif), il est néanmoins apte à capter au moins une partie de la lumière réfléchie par des revêtements photovoltaïques prévus sur d'autres éléments de support. En d'autres termes, le module photovoltaïque tridimensionnel selon la présente invention limite considérablement les risques d'obscurité générée par chaque élément de support sur les revêtements photovoltaïques disposés sur les faces de support des autres éléments de support. Enfin, même lorsqu'un revêtement photovoltaïque prévu sur un élément de support n'est ni directement, ni indirectement insolé, cela ne représente qu'une partie mimine des revêtements photovoltaïques appartenant au module photovoltaïque tridimensionnel qui n'est pas insolée.

Par conséquent, le module photovoltaïque tridimensionnel permet de produire, non seulement en instantanée, mais surtout annuellement, plus d'énergie par unité de surface qu'un panneau photovoltaïque classique et également qu'un module photovoltaïque tridimensionnel classique.

Le module photovoltaïque tridimensionnel peut en outre présenter une ou plusieurs des caractéristiques suivantes, prises seules ou en combinaison.

Selon un mode de réalisation de l'invention, le rapport de la surface développée des faces de support des éléments de support sur la surface au sol occupée par le module photovoltaïque tridimensionnel est supérieur à 3, et par exemple compris entre 4 et 6, et avantageusement entre 4,5 et 5,5. Ces dispositions assurent une production d'énergie, par unité de surface, relativement élevée comparativement à l'énergie produite, par unité de surface, par un module photovoltaïque tridimensionnel de l'art antérieur.

Selon un mode de réalisation de l'invention, l'axe central de la structure de support tridimensionnelle est configuré pour s'étendre sensiblement verticalement lorsque le module photovoltaïque tridimensionnel est disposé sur une surface horizontale.

Selon un mode de réalisation de l'invention, les revêtements photovoltaïques de ladite pluralité de revêtements photovoltaïques sont distincts les uns des autres et sont reliés en série et/ou en parallèle.

Selon un autre mode de réalisation de l'invention, au moins un revêtement photovoltaïque, et par exemple chacun des revêtements photovoltaïques, de ladite pluralité de revêtements photovoltaïques est flexible.

Selon un mode de réalisation de l'invention, chaque revêtement photovoltaïque comprend une pluralité de cellules photovoltaïques reliées en parallèle et/ou en série.

Selon un mode de réalisation de l'invention, les sommets des éléments de support sont répartis, et par exemple régulièrement répartis, autour de l'axe central de la structure de support tridimensionnelle.

Selon un mode de réalisation de l'invention, les sommets des éléments de support sont équidistants de l'axe central de la structure de support tridimensionnelle. En d'autres termes, les sommets des éléments de support sont disposés sur un cercle centré sur l'axe central de la structure de support tridimensionnelle.

Selon un mode de réalisation de l'invention, les lignes de crête sont sécantes en un point d'intersection situé sensiblement sur l'axe central de la structure de support tridimensionnelle.

Selon un mode de réalisation de l'invention, chaque ligne de crête est rectiligne.

Selon un mode de réalisation de l'invention, les lignes de crête sont régulièrement réparties autour de l'axe central de la structure de support tridimensionnelle.

Selon un mode de réalisation de l'invention, chacune des lignes de crête est inclinée par rapport à l'axe central d'un angle d'inclinaison compris entre 10 et 40°, avantageusement entre 20 et 30°, et par exemple d'environ 26°.

Selon un mode de réalisation de l'invention, chacune des faces de support présente une forme globalement triangulaire.

Selon un mode de réalisation de l'invention, chaque face de support comporte un premier bord s'étendant le long de la ligne de crête respective, un deuxième bord s'étendant jusqu'au sommet de l'élément de support respectif et un troisième bord opposé au sommet de l'élément de support respectif. De façon avantageuse, le deuxième bord de chaque face de support présente une extrémité qui est opposée au sommet respectif et qui est plus proche de l'axe central que le sommet respectif.

Selon un mode de réalisation de l'invention, le deuxième bord de chaque face de support est incliné par rapport à l'axe central de la structure de support tridimensionnelle, de telle sorte que l'extrémité dudit deuxième bord, qui est opposée au sommet respectif, est plus proche de l'axe central que le sommet respectif.

Selon un mode de réalisation de l'invention, chaque face de support de chaque élément de support est inclinée, par rapport à un plan de référence respectif qui est parallèle à l'axe central et qui passe par le troisième bord de ladite face de support, d'un angle d'inclinaison compris entre 5 et 10°, et par exemple d'environ 7°.

Selon un mode de réalisation de l'invention, le premier bord de chaque face de support présente une longueur comprise entre 35 et 55 mm, et avantageusement entre 40 et 50 mm, et par exemple d'environ 44 mm.

Selon un mode de réalisation de l'invention, le deuxième bord de chaque face de support présente une longueur comprise entre 55 et 75 mm, et avantageusement entre 60 et 70 mm, et par exemple d'environ 65 mm.

Selon un mode de réalisation de l'invention, le troisième bord de chaque face de support présente une longueur comprise entre 25 et 45 mm, et avantageusement entre 30 et 40 mm, et par exemple d'environ 34 mm.

Selon un mode de réalisation de l'invention, le nombre d'éléments de support est compris entre 3 et 6.

Selon un mode de réalisation de l'invention, pour chaque paire d'éléments de support adjacents de la structure de support tridimensionnelle, les faces de support adjacentes des deux éléments de support adjacents sont situées en regard l'une de l'autre.

Selon un mode de réalisation de l'invention, pour chaque paire d'éléments de support adjacents de la structure de support tridimensionnelle, les faces de support adjacentes des deux éléments de support adjacents sont reliées l'une à l'autre le long d'une zone de liaison qui est inclinée par rapport à l'axe central de la structure de support tridimensionnelle et qui s'étend vers le bas en s'éloignant de l'axe central de la structure de support tridimensionnelle.

Selon un mode de réalisation de l'invention, toutes les faces de support des éléments de support présentent des orientations différentes.

Selon un mode de réalisation de l'invention, les deux faces de support de chaque élément de support sont symétriques par rapport à un plan de symétrie respectif passant par la ligne de crête respective.

Selon un mode de réalisation de l'invention, les plans de symétrie des éléments de support sont sécants selon une ligne d'intersection qui est sensiblement confondue avec l'axe central de la structure de support tridimensionnelle.

Selon un mode de réalisation de l'invention, chaque élément de support présente un plan de symétrie passant par la ligne de crête respective.

Selon un mode de réalisation de l'invention, chaque élément de support présente, vue de dessus, une forme triangulaire, et par exemple une forme triangulaire équilatérale. En d'autres termes, une projection orthogonale de l'ensemble des points d'un élément de support sur un plan de référence perpendiculaire à l'axe central de la structure de support tridimensionnelle définit une surface de forme triangulaire, et de préférence de forme triangulaire équilatérale.

Selon un mode de réalisation de l'invention, un rapport du premier bord de chaque face de support sur un côté de la forme triangulaire équilatérale est compris entre 1,7 et 2,2, avantageusement entre 1,8 et 2, et par exemple entre 1,90 et 1,95.

Selon un mode de réalisation de l'invention, un rapport du deuxième bord de chaque face de support sur un côté de la forme triangulaire équilatérale est compris entre 2,7 et 3, avantageusement entre 2,8 et 2,9, et par exemple d'environ 2,86.

Selon un mode de réalisation de l'invention, un rapport du troisième bord de chaque face de support sur un côté de la forme triangulaire équilatérale est compris entre 1,2 et 1,8, avantageusement entre 1,3 et 1,7, et encore avantageusement entre 1,4 et 1,6.Selon un mode de réalisation de l'invention, un rapport de la hauteur du module photovoltaïque tridimensionnel sur un côté de la forme triangulaire équilatérale est compris entre 2,5 et 3,5, avantageusement entre 2,8 et 3,3, et par exemple entre 3 et 3,1.

Selon un mode de réalisation de l'invention, le module photovoltaïque tridimensionnel comporte en outre une embase qui est située en dessous de la structure de support tridimensionnelle et qui définit, au moins en partie, un logement interne dans lequel sont logés au moins en partie des fils électriquement conducteurs reliés aux revêtements photovoltaïques.

Selon un mode de réalisation de l'invention, l'embase présente une forme polygonale, et par exemple globalement hexagonale.

Selon un mode de réalisation de l'invention, la structure de support tridimensionnelle est monobloc.

Selon un mode de réalisation de l'invention, les éléments de support de la structure de support tridimensionnelle sont distincts les uns des autres, et la structure de support tridimensionnelle est formée par un assemblage des éléments de support.

Selon un mode de réalisation de l'invention, le module photovoltaïque tridimensionnel comporte une coiffe de protection, également nommée coiffe d'encapsulation, qui recouvre les revêtements photovoltaïques, la coiffe de protection étant en matériau transparent au rayonnement lumineux.

Selon un mode de réalisation de l'invention, la coiffe de protection est configurée pour combler au moins en partie un espace interne situé entre les éléments de support.

Selon un mode de réalisation de l'invention, la coiffe de protection est formée par durcissement d'une résine transparente.

Selon un mode de réalisation de l'invention, le module photovoltaïque tridimensionnel comporte un revêtement de surface antireflet disposé sur une face supérieure de la coiffe de protection.

Selon un mode de réalisation de l'invention, la face supérieure de la coiffe de protection s'étend sensiblement perpendiculairement à l'axe central de la structure de support tridimensionnelle.

Selon un mode de réalisation de l'invention, la face supérieure de la coiffe de protection s'étend au-delà des sommets des éléments de support.

Selon un mode de réalisation de l'invention, le module photovoltaïque tridimensionnel comprend une borne principale positive à laquelle sont reliées électriquement des bornes positives de tous les revêtements photovoltaïques, et une borne principale négative à laquelle sont reliées électriquement des bornes négatives de tous les revêtements photovoltaïques.

Selon un mode de réalisation de l'invention, le module photovoltaïque tridimensionnel présente une section transversale de forme polygonale, et par exemple hexagonale.

Selon un mode de réalisation de l'invention, le module photovoltaïque tridimensionnel présente une hauteur comprise entre 3 et 6 cm, et par exemple d'environ 4 cm. Une telle hauteur de module photovoltaïque tridimensionnel est notamment retenue lorsque le module photovoltaïque tridimensionnel est destiné à être installé sur des toits inclinés ou horizontaux. Le module photovoltaïque tridimensionnel pourrait cependant présenter une hauteur bien supérieure à 6 cm pour d'autres applications, par exemple lorsque le module photovoltaïque tridimensionnel est destiné à être installé selon une orientation sensiblement verticale.

La présente invention comporte en outre un dispositif photovoltaïque comportant une pluralité de modules photovoltaïques tridimensionnels selon la présente invention, lesdits modules photovoltaïques tridimensionnels étant disposés de manière adjacente. De façon avantageuse, le dispositif photovoltaïque s'étend selon un plan d'extension.

Selon un mode de réalisation de l'invention, pour chaque paire de modules photovoltaïques tridimensionnels adjacents du dispositif photovoltaïque, les embases des deux modules photovoltaïques tridimensionnels adjacents sont juxtaposées, c'est-à-dire sont au contact l'une de l'autre. De façon avantageuse, un côté d'une embase d'un module photovoltaïque tridimensionnel est configuré pour s'étendre le long et pour être en contact avec un côté d'une embase d'un module photovoltaïque tridimensionnel adjacent.

### Brève description des figures

La présente invention sera bien comprise à l'aide de la description qui suit en référence aux figures annexées, dans lesquelles des signes de références identiques correspondent à des éléments structurellement et/ou fonctionnellement identiques ou similaires.
Figure 1 est une vue schématique éclatée d'un module photovoltaïque tridimensionnel selon la présente invention.
Figure 2 est une vue en perspective de dessus d'une structure de support tridimensionnelle appartenant au module photovoltaïque tridimensionnel de la figure 1.
Figure 3 est une vue de dessus de la structure de support tridimensionnelle de la figure 2 équipée de revêtements photovoltaïques.
Figure 4 est une vue en perspective de côté de la structure de support tridimensionnelle de la figure 2.

### Description détaillée

Dans le présent document, on entend par « revêtement photovoltaïque » un élément photovoltaïque comprenant au moins une ou plusieurs cellule(s) photovoltaïque(s) supportée(s) ou non par une couche de substrat de base qui peut par exemple être flexible ou rigide.

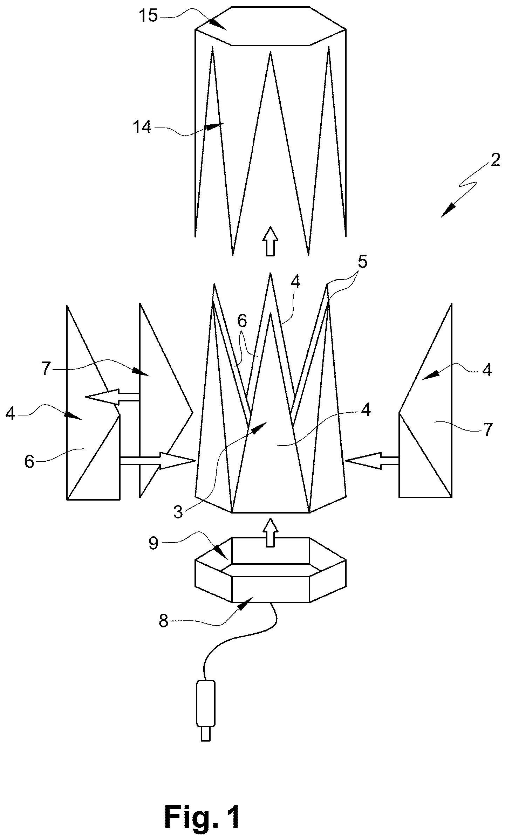

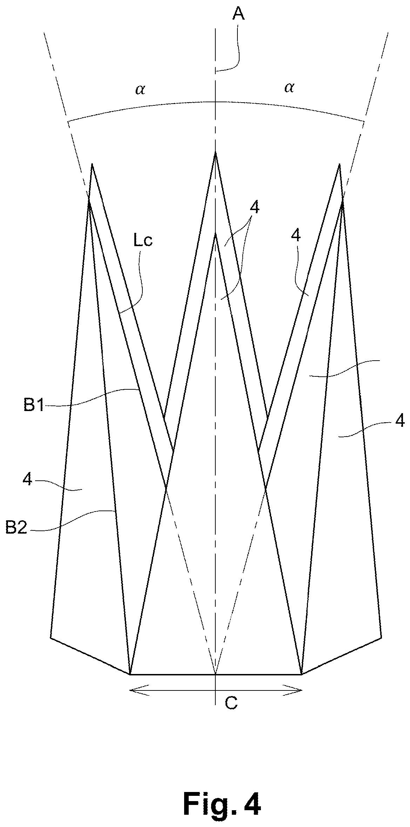

Les figures 1 à 4 représentent un module photovoltaïque tridimensionnel 2 selon un mode de réalisation de l'invention. De façon avantageuse, le module photovoltaïque tridimensionnel 2 présente une section transversale de forme polygonale, et par exemple hexagonale.

Le module photovoltaïque tridimensionnel 2 comporte une structure de support tridimensionnelle 3 comportant un axe central A qui est configuré pour s'étendre verticalement lorsque le module photovoltaïque tridimensionnel 2 est disposé sur une surface horizontale.

La structure de support tridimensionnelle 3 comporte une pluralité d'éléments de support 4 répartis autour de l'axe central A. De façon avantageuse, le nombre d'éléments de support 4 est compris entre 3 et 6. Selon le mode de réalisation représenté sur les figures, le nombre d'éléments de support 4 est égal à 6, et chaque élément de support 4 présente, vue de dessus, une forme triangulaire, et par exemple une forme triangulaire équilatérale. Cependant, une variante de réalisation de l'invention, le nombre d'éléments de support 4 pourrait être égal à 3, 4 ou 5.

La structure de support tridimensionnelle 3 peut par exemple être monobloc, et être obtenue par exemple par impression 3D. Cependant, la structure de support tridimensionnelle 3 pourrait également être obtenue par l'assemblage d'une pluralité d'éléments de support 4 distincts les uns des autres, c'est-à-dire formés indépendamment les uns des autres, par exemple par impression 3D.

Chaque élément de support 4 comporte un sommet 5 et deux faces de support 6 qui sont sensiblement planes. De façon avantageuse, toutes les faces de support 6 des éléments de support 4 présentent des orientations différentes. Selon un mode de réalisation de l'invention, le rapport de la surface développée des faces de support 6 des éléments de support 4 sur la surface au sol occupée par le module photovoltaïque tridimensionnel 2 est supérieur à 3, et par exemple compris entre 4 et 6, et avantageusement entre 4,5 et 5,5.

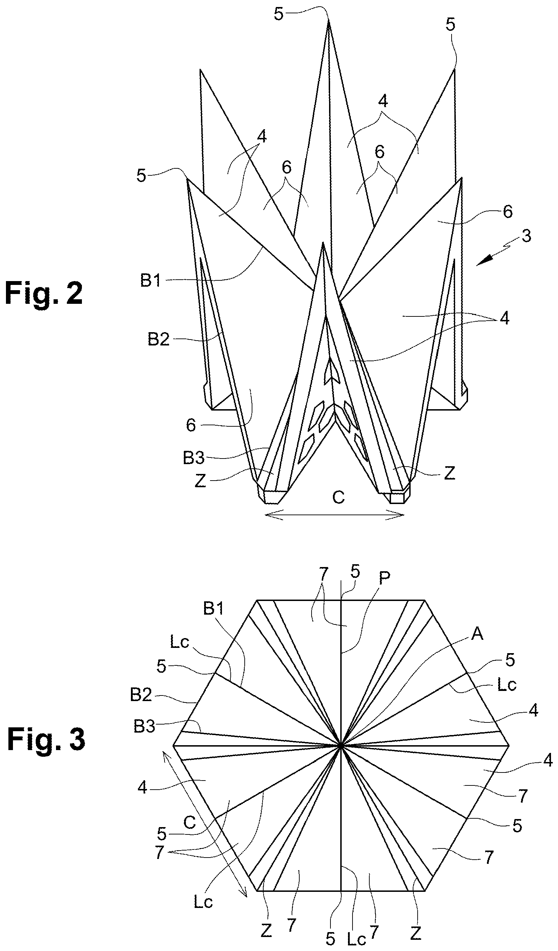

Comme montré plus particulièrement sur les figures 2 et 3, les deux faces de support 6 de chaque élément de support 4 sont reliées l'une à l'autre le long d'une ligne de crête Lc qui est rectiligne. La ligne de crête Lc de chacun des éléments de support 4 est inclinée par rapport à l'axe central A, et s'étend jusqu'au sommet 5 de l'élément de support 4 respectif en s'éloignant de l'axe central A.

De façon avantageuse, les lignes de crête Lc sont sécantes en un point d'intersection situé sur l'axe central A de la structure de support tridimensionnelle 3, et sont régulièrement réparties autour de l'axe central A. Chacune des lignes de crête Lc est plus particulièrement inclinée par rapport à l'axe central A d'un angle d'inclinaison α compris entre 10 et 40°, avantageusement entre 20 et 30°, et par exemple d'environ 26°.

Selon le mode de réalisation représenté sur les figures, chacune des faces de support 6 présente une forme globalement triangulaire, et comporte un premier bord B1 s'étendant le long de la ligne de crête Lc respective, un deuxième bord B2 s'étendant jusqu'au sommet 5 de l'élément de support 4 respectif et un troisième bord B3 opposé au sommet 5 de l'élément de support 4 respectif. De façon avantageuse, le deuxième bord B2 de chaque face de support 6 est incliné par rapport à l'axe central A de la structure de support tridimensionnelle 3, de telle sorte que l'extrémité dudit deuxième bord B2, qui est opposée au sommet 5 respectif, est plus proche de l'axe central A que le sommet 5 respectif.

Comme montré plus particulièrement sur la figure 2, pour chaque paire d'éléments de support 4 adjacents de la structure de support tridimensionnelle 3, les faces de support 6 adjacentes des deux éléments de support 4 adjacents sont situées en regard l'une de l'autre. De façon avantageuse, pour chaque paire d'éléments de support 4 adjacents de la structure de support tridimensionnelle 3, les faces de support 6 adjacentes des deux éléments de support 4 adjacents sont reliées l'une à l'autre le long d'une zone de liaison Z qui est inclinée par rapport à l'axe central A de la structure de support tridimensionnelle 3 et qui s'étend vers le bas en s'éloignant de l'axe central A de la structure de support tridimensionnelle 3. Ainsi, le troisième bord B3 de chacune des faces de support 6 s'étend le long de la zone de liaison Z respective.

Selon un mode de réalisation de l'invention :
- un rapport du premier bord B1 de chaque face de support 6 sur un côté C de la forme triangulaire équilatérale (définie par chaque élément de support 4 vue de dessus) est compris entre 1,7 et 2,2, avantageusement entre 1,8 et 2, encore avantageusement entre 1,90 et 1,95, et par exemple égal à environ 1,94 ou environ 1,92,
- un rapport du deuxième bord B2 de chaque face de support 6 sur un côté C de la forme triangulaire équilatérale précitée est compris entre 2,7 et 3, avantageusement entre 2,8 et 2,9, et par exemple d'environ 2,86,
- un rapport du troisième bord B3 de chaque face de support 6 sur un côté C de la forme triangulaire équilatérale précitée est compris entre 1,2 et 1,8, avantageusement entre 1,3 et 1,7, et encore avantageusement entre 1,4 et 1,6, et par exemple égal à environ 1,47 ou environ 1,58,
- un rapport de la hauteur du module photovoltaïque tridimensionnel 2 sur un côté C de la forme triangulaire équilatérale précitée est compris entre 2,5 et 3,5, avantageusement entre 2,8 et 3,3, et encore avantageusement entre 3 et 3,1, et par exemple égal à environ 3,06.

Comme montré également sur la figure 3, les sommets 5 des éléments de support 4 sont régulièrement répartis autour de l'axe central A de la structure de support tridimensionnelle 3, et sont équidistants de l'axe central A de la structure de support tridimensionnelle 3. En d'autres termes, les sommets 5 des éléments de support 4 sont disposés sur un cercle centré sur l'axe central A de la structure de support tridimensionnelle 3.

Selon le mode de réalisation représenté sur les figures, chaque élément de support 4 présente un plan de symétrie P passant par la ligne de crête Lc respective, et les plans de symétrie P des éléments de support 4 sont sécants selon une ligne d'intersection qui est confondue avec l'axe central A de la structure de support tridimensionnelle 3.

De façon avantageuse, chaque face de support 6 de chaque élément de support 4 est inclinée, par rapport à un plan de référence respectif qui est parallèle à l'axe central A et qui passe par le troisième bord B3 de ladite face de support 6, d'un angle d'inclinaison compris entre 5 et 10°, et par exemple d'environ 7°.

Le module photovoltaïque tridimensionnel 2 comporte en outre une pluralité de revêtements photovoltaïques 7 fixés à la structure de support tridimensionnelle 3. Chaque revêtement photovoltaïque 7 est plus particulièrement disposé sur une face de support 6 respective, et s'étend parallèlement à la face de support 6 respective. Chaque revêtement photovoltaïque 7 comprend avantageusement plusieurs cellules photovoltaïques reliées en parallèle et/ou en série, et recouvre partiellement ou entièrement la face de support 6 respective. Les cellules photovoltaïques de chaque revêtement photovoltaïque 7 peuvent par exemple être supportées par une couche de substrat de base. De façon avantageuse, chaque revêtement photovoltaïque 7 est de forme globalement triangulaire, et présente des dimensions sensiblement identiques à celles de chaque face de support 6. Selon un mode de réalisation de l'invention, chaque revêtement photovoltaïque 7 présente une épaisseur d'environ 1 mm.

Selon le mode de réalisation représenté sur les figures, les revêtements photovoltaïques 7 de ladite pluralité de revêtements photovoltaïques sont distincts les uns des autres et reliés en série et/ou en parallèle. De façon avantageuse, au moins un revêtement photovoltaïque 7, et par exemple chacun des revêtements photovoltaïques 7, peut être flexible.

Le module photovoltaïque tridimensionnel 2 comporte également une embase 8 qui est située en dessous de la structure de support tridimensionnelle 3 et qui présente une forme polygonale, et par exemple globalement hexagonale. L'embase 8 délimite, au moins en partie, un logement interne 9 dans lequel sont logés au moins en partie des fils électriquement conducteurs reliés aux revêtements photovoltaïques 7. Le module photovoltaïque tridimensionnel 2 comprend en outre une borne principale positive à laquelle sont reliées électriquement des bornes positives de tous les revêtements photovoltaïques 7, et une borne principale négative à laquelle sont reliées électriquement des bornes négatives de tous les revêtements photovoltaïques 7.

Comme montré sur la figure 1, le module photovoltaïque tridimensionnel 2 comporte en outre une coiffe de protection 14, également nommée coiffe d'encapsulation, qui recouvre et protège les revêtements photovoltaïques 7. La coiffe de protection 14 est réalisée en matériau transparent au rayonnement lumineux, et est par exemple formée par durcissement d'une résine transparente. La coiffe de protection 14 est plus particulièrement configurée pour combler un espace interne situé entre les éléments de support 4.

Selon le mode de réalisation représenté sur les figures, la coiffe de protection 14 comporte une face supérieure qui s'étend au-delà des sommets 5 des éléments de support 4, et qui s'étend perpendiculairement à l'axe central A de la structure de support tridimensionnelle 3. De façon avantageuse, la coiffe de protection 14 est configurée de telle sorte que le module photovoltaïque tridimensionnel 2 présente une forme générale de prisme dont chacune des bases présente une forme globalement hexagonale.

Le module photovoltaïque tridimensionnel 2 comporte également un revêtement de surface antireflet 15 disposé sur une face supérieure de la coiffe de protection 14. Néanmoins, si la coiffe de protection 14 est réalisée en un matériau ayant des propriétés antireflets, le module photovoltaïque tridimensionnel 2 pourrait être dépourvu du revêtement de surface antireflet 15.

Plusieurs modules photovoltaïques tridimensionnels 2 selon la présente invention pourraient être assemblés de manière à former un dispositif photovoltaïque s'étendant selon un plan d'extension, et présentant donc une forme externe similaire à celle d'un panneau photovoltaïque classique. A cet effet, les modules photovoltaïques tridimensionnels 2 sont disposés de manière adjacente, et sont reliés en série et/ou en parallèle par connexion de leurs bornes principales positives et négatives. De façon avantageuse, pour chaque paire de modules photovoltaïques tridimensionnels 2 adjacents du dispositif photovoltaïque, les embases 8 des deux modules photovoltaïques tridimensionnels 2 adjacents sont juxtaposées, c'est-à-dire sont au contact l'une de l'autre, au niveau de leurs côtés adjacents. Un tel dispositif photovoltaïque comporte avantageusement un support ou cadre de support délimitant un compartiment dans lequel sont disposés les différents modules photovoltaïques tridimensionnels 2.

Le fait que l'embase 8 de chaque module photovoltaïque tridimensionnel 2 présente une forme hexagonale permet avantageusement d'obtenir un agencement en réseau optimisé des différents modules photovoltaïques tridimensionnels 2 dudit dispositif photovoltaïque.

Un dispositif photovoltaïque selon la présente invention peut être installé dans un nombre d'emplacements plus importants qu'un dispositif photovoltaïque formé de modules photovoltaïques tridimensionnels de l'art antérieur, et ce avec moins de contraintes d'orientation et d'inclinaison. Un dispositif photovoltaïque selon la présente invention peut notamment être installé sur des toits inclinés orientés Est, Sud ou Ouest, sur des toits horizontaux ou au sol sans support additionnel, sur des façades orientées Est, Sud ou Ouest (et donc selon une orientation sensiblement verticale), ou encore en remplacement de tous dispositifs photovoltaïques existants revêtus de matière photovoltaïque avec des caractéristiques techniques identiques avec au moins trois fois plus de production annuelle d'électricité pour la même surface.

Un dispositif photovoltaïque selon la présente invention peut également être installé sur tous les moyens de locomotion existants à ce jour et à venir, et ce du fait qu'un tel dispositif photovoltaïque présente une production annuelle d'énergie au moins trois fois plus importante que celle de dispositifs photovoltaïques de l'art antérieur revêtus de matière photovoltaïque avec des caractéristiques techniques identiques et s'affranchit de la plupart des contraintes d'orientation.

Bien entendu, la présente invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention tel que défini par l'objet des revendications.

## Revendications

1. Module photovoltaïque tridimensionnel (2) comportant :
- une structure de support tridimensionnelle (3) comportant un axe central (A) et une pluralité d'éléments de support (4) répartis autour de l'axe central (A) de la structure de support tridimensionnelle (3), chaque élément de support (4) comportant un sommet (5) et deux faces de support (6) qui sont sensiblement planes et qui sont reliées l'une à l'autre le long d'une ligne de crête (Lc), la ligne de crête (Lc) de chacun des éléments de support (4) étant inclinée par rapport à l'axe central (A) de la structure de support tridimensionnelle (3) et s'étendant jusqu'au sommet (5) de l'élément de support (4) respectif en s'éloignant de l'axe central (A) de la structure de support tridimensionnelle (3),
- une pluralité de revêtements photovoltaïques (7) fixés à la structure de support tridimensionnelle (3), chaque revêtement photovoltaïque (7) étant disposé sur une face de support (6) respective et s'étendant sensiblement parallèlement à la face de support (6) respective, chaque revêtement photovoltaïque (7) comprenant au moins une cellule photovoltaïque et recouvrant au moins en partie la face de support (6) respective.

2. Module photovoltaïque tridimensionnel (2) selon la revendication 1, dans lequel les sommets (5) des éléments de support (4) sont répartis autour de l'axe central (A) de la structure de support tridimensionnelle (3).

3. Module photovoltaïque tridimensionnel (2) selon la revendication 1 ou 2, dans lequel les sommets (5) des éléments de support (4) sont équidistants de l'axe central (A) de la structure de support tridimensionnelle (3).

4. Module photovoltaïque tridimensionnel (2) selon l'une quelconque des revendications 1 à 3, dans lequel les lignes de crête (Lc) sont sécantes en un point d'intersection situé sensiblement sur l'axe central (A) de la structure de support tridimensionnelle (3).

5. Module photovoltaïque tridimensionnel (2) selon l'une quelconque des revendications 1 à 4, dans lequel chacune des lignes de crête (Lc) est inclinée par rapport à l'axe central (A) d'un angle d'inclinaison (α) compris entre 10 et 40°, avantageusement entre 20 et 30°, et par exemple d'environ 26°.

6. Module photovoltaïque tridimensionnel (2) selon l'une quelconque des revendications 1 à 5, dans lequel chacune des faces de support (6) présente une forme globalement triangulaire.

7. Module photovoltaïque tridimensionnel (2) selon l'une quelconque des revendications 1 à 6, dans lequel le nombre d'éléments de support (4) est compris entre 3 et 6.

8. Module photovoltaïque tridimensionnel (2) selon l'une quelconque des revendications 1 à 7, dans lequel les deux faces de support (6) de chaque élément de support (4) sont symétriques par rapport à un plan de symétrie (P) respectif passant par la ligne de crête (Lc) respective.

9. Module photovoltaïque tridimensionnel (2) selon la revendication 8, dans lequel les plans de symétrie (P) des éléments de support (4) sont sécants selon une ligne d'intersection qui est sensiblement confondue avec l'axe central (A) de la structure de support tridimensionnelle (3).

10. Module photovoltaïque tridimensionnel (2) selon l'une quelconque des revendications 1 à 9, lequel comporte en outre une embase (8) qui est située en dessous de la structure de support tridimensionnelle (3) et qui définit, au moins en partie, un logement interne (9) dans lequel sont logés au moins en partie des fils électriquement conducteurs reliés aux revêtements photovoltaïques (7).

11. Module photovoltaïque tridimensionnel (2) selon la revendication 10, dans lequel l'embase (8) présente une forme polygonale, et par exemple globalement hexagonale.

12. Module photovoltaïque tridimensionnel (2) selon l'une quelconque des revendications 1 à 11, lequel comporte une coiffe de protection (14) qui recouvre les revêtements photovoltaïques (7), la coiffe de protection (14) étant en matériau transparent au rayonnement lumineux.

13. Module photovoltaïque tridimensionnel (2) selon l'une quelconque des revendications 1 à 12, lequel comporte un revêtement de surface antireflet (15) disposé sur une face supérieure de la coiffe de protection (14).

14. Dispositif photovoltaïque comportant une pluralité de modules photovoltaïques tridimensionnels selon l'une quelconque des revendications précédentes, lesdits modules photovoltaïques tridimensionnels étant disposés de manière adjacente.

## Patentansprüche

1. Dreidimensionales Photovoltaikmodul (2), das Folgendes aufweist:
- eine dreidimensionale Trägerstruktur (3), die eine Mittelachse (A) und eine Vielzahl von Trägerelementen (4) aufweist, die um die Mittelachse (A) der dreidimensionalen Trägerstruktur (3) verteilt sind, wobei jedes Trägerelement (4) einen Scheitelpunkt (5) und zwei Trägerflächen (6) aufweist, die im Wesentlichen plan sind und die entlang einer Spitzenlinie (Lc) miteinander verbunden sind, wobei die Spitzenlinie (Lc) jedes der Trägerelemente (4) gegenüber der Mittelachse (A) der dreidimensionalen Trägerstruktur (3) geneigt ist und sich von der Mittelachse (A) der dreidimensionalen Trägerstruktur (3) weg bis zum Scheitelpunkt (5) des jeweiligen Trägerelements (4) erstreckt,
- eine Vielzahl von Photovoltaik-Beschichtungen (7), die an der dreidimensionalen Trägerstruktur (3) befestigt sind, wobei jede Photovoltaik-Beschichtung (7) auf einer jeweiligen Trägerfläche (6) angeordnet ist und sich im Wesentlichen parallel zur jeweiligen Trägerfläche (6) erstreckt, wobei jede Photovoltaik-Beschichtung (7) mindestens eine Photovoltaikzelle umfasst und mindestens teilweise die jeweilige Trägerfläche (6) abdeckt.

2. Dreidimensionales Photovoltaikmodul (2) nach Anspruch 1, wobei die Scheitelpunkte (5) der Trägerelemente (4) um die Mittelachse (A) der dreidimensionalen Trägerstruktur (3) verteilt sind.

3. Dreidimensionales Photovoltaikmodul (2) nach Anspruch 1 oder 2, wobei die Scheitelpunkte (5) der Trägerelemente (4) gleich weit von der Mittelachse (A) der dreidimensionalen Trägerstruktur (3) entfernt sind.

4. Dreidimensionales Photovoltaikmodul (2) nach einem der Ansprüche 1 bis 3, wobei sich die Spitzenlinien (Lc) an einem Schnittpunkt schneiden, der sich im Wesentlichen auf der Mittelachse (A) der dreidimensionalen Trägerstruktur (3) befindet.

5. Dreidimensionales Photovoltaikmodul (2) nach einem der Ansprüche 1 bis 4, wobei jede der Spitzenlinien (Lc) gegenüber der Mittelachse (A) um einen Neigungswinkel (α) zwischen 10 und 40°, vorteilhafterweise zwischen 20 und 30°, und beispielsweise um etwa 26° geneigt ist.

6. Dreidimensionales Photovoltaikmodul (2) nach einem der Ansprüche 1 bis 5, wobei jede der Trägerflächen (6) eine insgesamt dreieckige Form aufweist.

7. Dreidimensionales Photovoltaikmodul (2) nach einem der Ansprüche 1 bis 6, wobei die Anzahl der Trägerelemente (4) zwischen 3 und 6 liegt.

8. Dreidimensionales Photovoltaikmodul (2) nach einem der Ansprüche 1 bis 7, wobei die beiden Trägerflächen (6) jedes Trägerelements (4) symmetrisch zu einer jeweiligen Symmetrieebene (P) sind, die durch die jeweilige Spitzenlinie (Lc) verläuft.

9. Dreidimensionales Photovoltaikmodul (2) nach Anspruch 8, wobei sich die Symmetrieebenen (P) der Trägerelemente (4) entlang einer Schnittlinie schneiden, die im Wesentlichen mit der Mittelachse (A) der dreidimensionalen Trägerstruktur (3) zusammenfällt.

10. Dreidimensionales Photovoltaikmodul (2) nach einem der Ansprüche 1 bis 9, das ferner einen Sockel (8) umfasst, der sich unterhalb der dreidimensionalen Trägerstruktur (3) befindet und der mindestens teilweise eine innere Aufnahme (9) definiert, in der mindestens teilweise die mit den Photovoltaikbeschichtungen (7) verbundenen elektrisch leitenden Drähte untergebracht sind.

11. Dreidimensionales Photovoltaikmodul (2) nach Anspruch 10, wobei der Sockel (8) eine polygonale und beispielsweise insgesamt sechseckige Form aufweist.

12. Dreidimensionales Photovoltaikmodul (2) nach einem der Ansprüche 1 bis 11, das eine Schutzkappe (14) aufweist, die die Photovoltaikbeschichtungen (7) abdeckt, wobei die Schutzkappe (14) aus für Lichtstrahlung transparentem Material besteht.

13. Dreidimensionales Photovoltaikmodul (2) nach einem der Ansprüche 1 bis 12, das eine auf einer oberen Fläche der Schutzkappe (14) angeordnete Antireflexions-Oberflächenbeschichtung (15) aufweist.

14. Photovoltaikvorrichtung, die eine Vielzahl von dreidimensionalen Photovoltaikmodulen nach einem der vorhergehenden Ansprüche aufweist, wobei die dreidimensionalen Photovoltaikmodule nebeneinander angeordnet sind.

## Claims

1. A three-dimensional photovoltaic module (2) including:
- a three-dimensional support structure (3) including a central axis (A) and a plurality of support elements (4) distributed around the central axis (A) of the three-dimensional support structure (3), each support element (4) including a vertex (5) and two support faces (6) which are substantially planar and which are connected to each other along a ridge line (Lc), the ridge line (Lc) of each of the support elements (4) being inclined with respect to the central axis (A) of the three-dimensional support structure (3) and extending up to the vertex (5) of the respective support element (4) while getting away from the central axis (A) of the three-dimensional support structure (3),
- a plurality of photovoltaic coatings (7) fastened to the three-dimensional support structure (3), each photovoltaic coating (7) being arranged on a respective support face (6) and extending substantially parallel to the respective support face (6), each photovoltaic coating (7) comprising at least one photovoltaic cell and covering at least partially the respective support face (6).

2. The three-dimensional photovoltaic module (2) according to claim 1, wherein the vertices (5) of the support elements (4) are distributed around the central axis (A) of the three-dimensional support structure (3).

3. The three-dimensional photovoltaic module (2) according to claim 1 or 2, wherein the vertices (5) of the support elements (4) are equidistant from the central axis (A) of the three-dimensional support structure (3).

4. The three-dimensional photovoltaic module (2) according to any one of claims 1 to 3, wherein the ridge lines (Lc) intersect at a point of intersection located substantially on the central axis (A) of the three-dimensional support structure (3).

5. The three-dimensional photovoltaic module (2) according to any one of claims 1 to 4, wherein each of the ridge lines (Lc) is inclined with respect to the central axis (A) by an angle of inclination (α) comprised between 10 and 40°, advantageously between 20 and 30°, and for example around 26°.

6. The three-dimensional photovoltaic module (2) according to any one of claims 1 to 5, wherein each of the support faces (6) has a generally triangular shape.

7. The three-dimensional photovoltaic module (2) according to any one of claims 1 to 6, wherein the number of support elements (4) is comprised between 3 and 6.

8. The three-dimensional photovoltaic module (2) according to any one of claims 1 to 7, wherein the two support faces (6) of each support element (4) are symmetrical with respect to a respective plane of symmetry (P) passing through the respective ridge line (Lc).

9. The three-dimensional photovoltaic module (2) according to claim 8, wherein the planes of symmetry (P) of the support elements (4) intersect according to a line of intersection which is substantially coincident with the central axis (A) of the three-dimensional support structure (3).

10. The three-dimensional photovoltaic module (2) according to any one of claims 1 to 9, which further includes a base (8) which is located below the three-dimensional support structure (3) and which defines, at least in part, an inner housing (9) in which electrically-conductive wires, connected to the photovoltaic coatings (7), are at least partially housed.

11. The three-dimensional photovoltaic module (2) according to claim 10, wherein the base (8) has a polygonal shape, and for example generally hexagonal.

12. The three-dimensional photovoltaic module (2) according to any one of claims 1 to 11, which includes a protective cap (14) which covers the photovoltaic coatings (7), the protective cap (14) being made of a material transparent to light radiation.

13. The three-dimensional photovoltaic module (2) according to any one of claims 1 to 12, which includes an antireflective surface coating (15) arranged on an upper face of the protective cap (14).

14. A photovoltaic device including a plurality of three-dimensional photovoltaic modules according to any one of the preceding claims, said three-dimensional photovoltaic modules being arranged adjacently.
